# EUROPEAN PATENT SPECIFICATION

(11) **EP 3 238 162 B1**
(45) Date of publication and mention of the grant of the patent: **20.11.2019**
(21) Application number: 15873866.6
(22) Date of filing: 07.10.2015
(51) Int. Cl.: G06Q 50/06, G06F 11/34, G06F 11/30

(54) **FORECAST FOR DEMAND OF ENERGY**
PROGNOSE FÜR ENERGIEBEDARF
PRÉVISION D'UNE DEMANDE D'ÉNERGIE

(30) Priority: 24.12.2014 US 201414582988
(43) Date of publication of application: 01.11.2017
(73) Proprietor: Intel Corporation, Santa Clara, CA 95054 (US)
(72) Inventor: BODAS, Devadatta, V., Federal Way, WA 98023-8144 (US); RAJAPPA, Muralidhar, Chandler, AZ 85226 (US); SONG, Justin, J., Olympia, WA 98516 (US); HOFFMAN, Andy, Gilbert AZ 85298 (US)
(74) Representative: HGF Limited
(86) International application number: PCT/US2015/054440
(87) International publication number: WO 2016/105626

(56) References cited:
- US-A1- 2006 241 880
- US-A1- 2009 119 233
- US-A1- 2010 094 475
- US-A1- 2010 257 531
- US-A1- 2012 072 389
- US-A1- 2014 075 222
- US-A1- 2014 149 752
- US-A1- 2014 189 301
- US-B1- 8 631 411

## Description

### Technical Field

The present techniques relate generally to distributed computing. More particularly, the techniques relate to power forecasting of distributed computing.

### Background Art

High Performance Computing (HPC) and distributed computing may facilitate scientists and engineers to solve complex science, engineering, and business problems using applications that benefit from high bandwidth, low latency networking, and very high compute capabilities. Such HPC systems may also execute data storage and retrieval, perform more straightforward tasks, and so on. Unfortunately, HPC systems, which generally have thousands of compute nodes performing tasks, typically consume significant power. Such may be especially problematic in the "Big Data" era. Further, variations in power consumption and issues of power allocation may also be problematic.

The competitive business of data and computing services drives manufacturers in the continuous improvement of their processes and products in order to lower production costs and deliver reliable service. Indeed, as technologies advance in services for data, computing, and telecommunications, a competitive need exists to continuously increase consistency of service and the efficiency of power utilization.

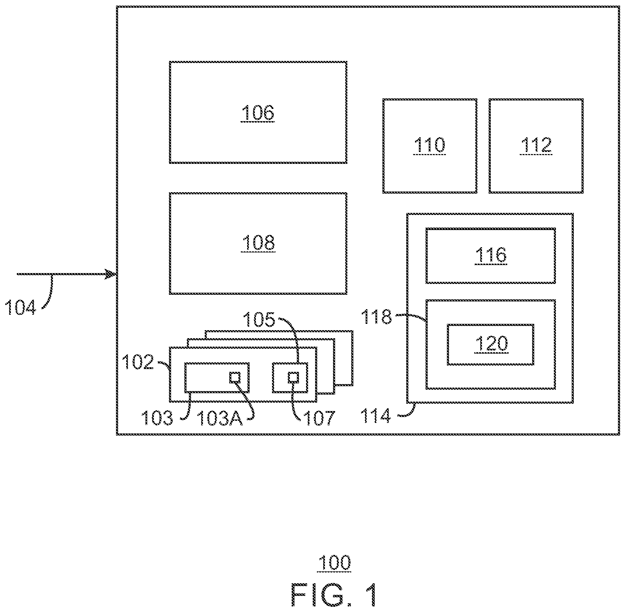

FIG. 1 is a diagrammatical representation of a distributed computing facility 100, such as an HPC facility, Big Data analytics facility, datacenter, telecommunications center, and so on. The depiction of the computing facility 100 may represent a single facility or multiple facilities across geographical locations. In the illustrated embodiment, the distributed computing facility 100 has nodes 102. In examples, the number of nodes 102 may be as many as 2, 4, 16, 100, 1,000, 2,000, 5,000, 10,000, 20,000, 40,000, 60,000, 100,000, and 1,000,000, or greater. In / certain embodiments, the nodes 102 may generally be compute nodes and also include operating system (OS) nodes, input/output (I/O) nodes, and so on.

Each compute node 102 typically includes one or more processors 103, such as a central processing unit (CPU). Indeed, each node 102 may have a CPU processor package including multiple processors 103. Further, each processor 103 has one or more processing cores 103A. For example, a processor 103 may have ten cores 103A. In addition, each node 102 may have memory 105 storing code 107 (i.e., logic, modules, instructions, etc.) executable by the processor 103 or other processor. The code 107 may include a node manager, job manager, and the like, to facilitate execution of tasks and adjustment of the tasks with respect to power and performance. The nodes 102 may include other hardware, software, and firmware, may be housed in racks, for example, and may be grouped into systems or groups of nodes 102, and so forth.

The facility 100 receives power, as indicated by reference numeral 104. The power may be electricity received from one or more electricity providers such as a utility company. As can be appreciated, the compute nodes 102 and other computing devices in the facility 100 generally require power or electricity as electronic devices in computing and executing tasks. Further, other systems such as lighting and cooling systems, represented by blocks 106 and 108, respectively, may consume power. Moreover, in certain embodiments, the facility 100 may include alternate or local power generation systems 110 (e.g., diesel generators, etc.) and/or battery or energy storage systems 112.

In addition, the facility 100 generally includes one or more computing devices 114 (e.g., servers) which may be disposed locally within the facility 100 and/or remote to the facility 100. The computing device(s) 114 may include one or more processors 116 (e.g., CPU) and memory 118. Various manager modules or code 120 may be stored in the memory 118 and executable by the processor(s) 116. For example, the executable code 120 and/or the aforementioned executable code 107 on the nodes 102 may include a job manager that may assign and manage tasks across the compute nodes 102, including with respect to power consumption. Other examples of manager modules in the server executable code 120 and/or in the node executable code 107 include a facility power manager, resource manager, system power performance managers (e.g., for groups of nodes), rack managers, node managers, and so on. Moreover, a compute node can be a server or a board, and/or several compute nodes may be on one board.

It should be noted that while the discussion in this disclosure may at times focus on datacenters, it should be understood that the term "datacenter" as used herein can refer to a variety of distributing computing facilities and configurations. For example, a distributed computing facility or datacenter may be high performance computing (HPC), Big Data analytics, search engine facility, telecommunications center, web services center, cloud computing facility, data processing facility, and so forth.

US 2014/0075222 describes a system and method for managing energy consumption in a compute environment.

US 2010/0257531 relates to scheduling of jobs of a multi-node computer system based on environmental impact.

### Summary of the Invention

Demand for energy in datacenters is growing. Many energy producers or utility providers are unable to meet this growing demand. This problem is experienced throughout the world. Datacenters are generally built to be used ten years or more. Traditionally, datacenter demand for allocation of power may be governed by maximum power need of the data center over a period of 2-3 years, for example. As a result, actual use of power at the datacenter may be significantly lower than allocation.

Utility companies may rely on several different ways of generating power including nuclear, hydro, coal, diesel, geothermal, wind, solar, etc. Most high capacity generators generally have long start-up and shut-down times. Electrical energy must generally be consumed the moment it is generated. These limitations may require that utility companies have a good forecast on demand for energy to manage multiple sources of energy generation. Conventionally, these demands are communicated manually and a forecast is done months in advance. Both of these factors drive conservative and inaccurate forecasts.

A problem is high operational cost. The cost of energy for a datacenter may be divided into at least two parts: meter charge and demand charge. When datacenters do not use allocated power, the utility demand charge can become significant. Another problem is low energy efficiency for the electricity providers. In other words, because of the aforementioned problems with forecasting and allocation, generated power is not diverted as per plan by the utility companies. Therefore, the efficiency of the power or electricity grid may be poor. Yet another problem for the utility provider (and problem and possible opportunity for the user facility) is wild swings in pricing of energy. Utility companies and suppliers try to sell excess energy on the energy market. Usually, they have to sell excess energy at a significant discount rate. On the other hand, when user demand exceeds the forecast, the user consequently buys scarce energy at a premium price. In all, there is a generally very wide variation in pricing of energy, such as from $125 per megawatt-hour (MWh) to sometimes close to zero. This generally causes an enormous challenge to price control.

An interface to facilitate users (e.g., datacenters) to change their specified demand and take advantage of energy spot pricing may be beneficial to the user. Such may be especially beneficial to the user if the user can negotiate this change in specified demand every day, every few hours, or every few minutes. In all, the aforementioned power supply, allocation, and pricing issues call out for better forecast and automation to facilitate just-in-time supply of energy.

The invention is defined by the appended claims.

In some embodiments, a facility such as datacenter or other distributed computing facility, may use mechanisms including automated mechanisms, to negotiate demand and allocation with energy producers and utility companies or providers. Example techniques that may be implemented include methods and distributed computing facilities to: (1) develop energy forecast on a regular (i.e., frequent) basis, (2) adjust level of demand (including negotiated specified demand) as well as source of energy based upon incentive programs and spot pricing of the energy, and (3) adjust use of local energy generation and storage based on changing demand and pricing.

Traditionally, a forecast for power is based upon power and cooling capability of the datacenter. For example, a datacenter with a system of 20,000 nodes (e.g., compute nodes), and power need capability (computing, cooling, lighting, etc.) of 7.5 megawatt (MW), may ask for an allocation of 7.5 MW. However, actual power consumption at the datacenter in this example may vary between 2.5 MW to 7.3 MW, resulting in unused, wasted, and/or stranded power. Further, the datacenter may have capability to generate power. In this example, the production capability is to generate 4 MW with diesel generators and 0.5 MW from solar. Conventionally, these generation resources and investment may be beneficial in protecting against power supply failure but not to help reduce the cost of energy.

### BRIEF DESCRIPTION OF DRAWINGS

FIG. 1 is a diagrammatical representation of an exemplary distributed computing facility in accordance with embodiments of the present techniques.
FIG. 2 is a job-sequence diagram depicting jobs running on a system of nodes over time in accordance with embodiments of the present techniques.
FIG. 3 is a power diagram of power consumption of the system of FIG. 2 executing the sequence of jobs over time in accordance with embodiments of the present techniques.
FIG. 4 is a power diagram of power consumption of the system of FIGS. 2 and 3 executing the sequence of jobs over time, including the use of local generation in accordance with embodiments of the present techniques.
FIG. 5 is a block diagram depicting an example of a tangible non-transitory, computer-readable medium that can facilitate power forecasting in accordance with embodiments of the present techniques.
FIG. 6 is a block flow diagram of a method of forecasting power consumption at a distributed computing facility in accordance with embodiments of the present techniques.
FIG. 7 is a method of forecasting power consumption a facility, such as a distributed computing facility, in accordance with embodiments of the present techniques.
FIG. 8 is a diagram of an example facility for distributed computing having multiple HPC systems of nodes for computing, in accordance with embodiments of the present techniques.

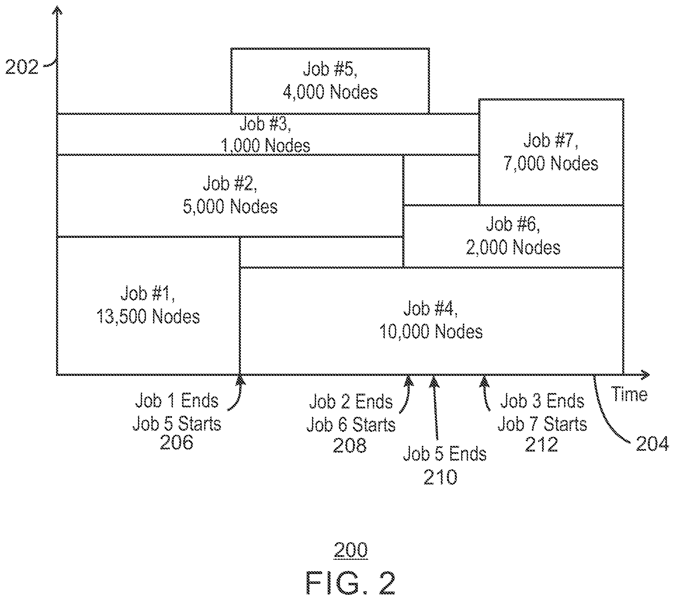

The same numbers are used throughout the disclosure and the figures to reference like components and features. Numbers in the 100 series refer to features originally found in Fig. 1; numbers in the 200 series refer to features originally found in Fig. 2; and so on.

### DETAILED DESCRIPTION

FIG. 2 is a job-sequence diagram 200 depicting jobs 202 (e.g., HPC jobs) running (executing) on a system of nodes (e.g., HPC system) over time 204. In the illustrated example, the HPC system has 20,000 nodes, and the HPC system jobs 200 include Job #1, Job #2, Job #3, Job #4, Job #5, Job #6, and Job #7. At the initial time 204, Job #1, Job #2, and Job # 3 start or are already running. Over the time 204, Job #4, Job #5, Job #6, and Job #7 start, and Job #1, Job #2, Job #3, and Job #4 reach completion. Again, the diagram 200 illustrates am exemplary sequence of job execution of jobs on an HPC system having 20,000 nodes. The number of nodes per job (at which the job executes) is noted in the job boxes.

The arrow 206 indicates the time 204 at which Job #1 ends, Job #4 starts, and Job #5 starts, and in which the number of nodes executing jobs in the HPC system changes from 19,500 nodes to 20,000 nodes. Thus at this point in time, all nodes of the HPC system are executing jobs, performing computation. Then, the arrow 208 indicates the time 204 that Job #2 ends and Job #6 starts, and in which the number of nodes executing jobs changes from 20,000 nodes to 17,000 nodes. Arrow 210 notes the time 204 that Job #5 ends and the number of nodes executing jobs decreases from 17,000 nodes to 13,000 nodes. Lastly, the time 204 at which Job #3 ends and Job #7 starts is indicated at arrow 212. At this point in time 204, the number of executing nodes of the HPC system increases from 13,000 nodes to 19,000 nodes.

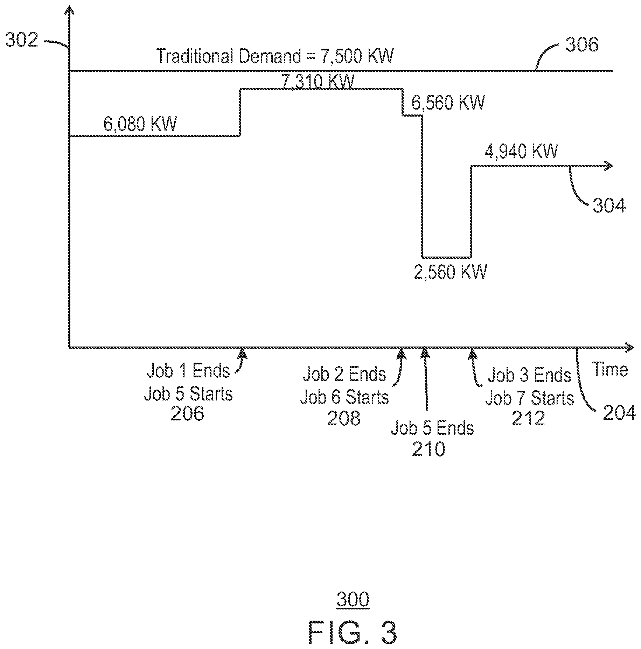

FIG. 3 is a power diagram 300 (e.g., a forecast) of power consumption 302 in kilowatts (kW) of the system of FIG. 2 executing the sequence of jobs over time 204. The arrows 206, 208, 210, 212 from FIG. 2 noting start and end times of jobs are given in FIG. 3.

The power curve 304 notes the power consumption of the HPC system over time 204. Numerical values of the power consumption in this example are listed. For instance, the system power consumption at the beginning of the time 204 and for a time period thereafter is 6,080 KW as listed. A change in power is realized at the time 204 point noted by arrow 206, and in which the facility or HPC system power increases to 7,310 KW. Then, the power further changes through the sequencing of the jobs. The power curve 304 may be the actual implemented power consumption of the jobs as executed and/or may be forecasted power consumption of the HPC system prior to actual execution of the jobs.

A specified allocated demand 306 for the HPC system, as negotiated with a utility provider, for example, does not change over the depicted time 204. In the illustrated example, the specified allocated demand is 7,500 KW. The difference between the allocated demand 306 line and the power curve 304 may represent energy allocated but unused. The depicted allocated demand 306 may be traditional in a sense that this specified or allocated demand 306 remains the same and is not renegotiated over shorter periods of time.

An aspect of embodiments of the present techniques may use the power curve 304 from job sequencing to communicate a forecast of demand to the utility provider. The forecast may give a more accurate amount of power needed for the facility or the HPC system than specified allocation. Some embodiments of this forecasting do not consider or add use of any local power storage or generation, for example. In all, these types of power forecasts base on job sequencing, for example, and the further actions of related communication with the utility provider or supplier, may help the datacenter to keep its demand charge lower.

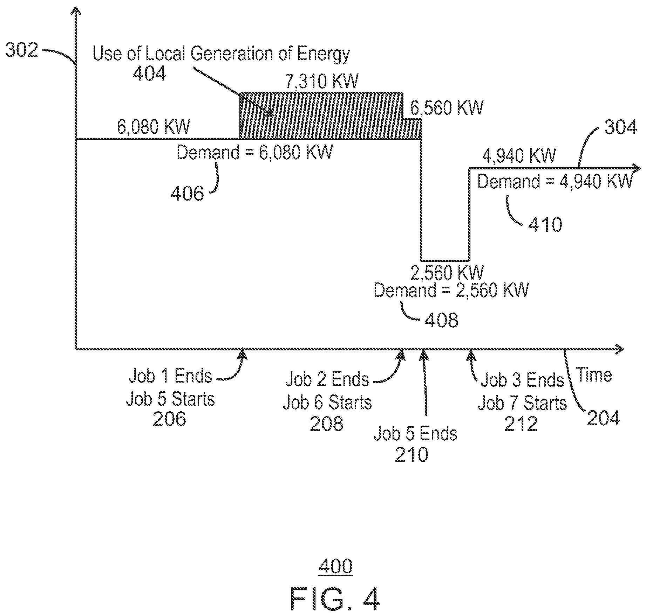

Additionally, in certain embodiments, local energy may be employed to keep demand low. The use of local energy may reduce both demand charge and meter charge for energy. Furthermore, the use of local energy may facilitate adjustment of actual demand and/or specified demand to take advantage of incentive programs offered by the utility provider, and to pursue other business opportunities with respect to electrical supply pricing, for instance. The local energy generation may include non-renewable energy generation such as with diesel generators, and also include renewable energy generation such as with solar, wind, geothermal, and so forth. FIG. 4 represents demand comprehending local generation of energy.

FIG. 4 is a power diagram 400 (e.g., a forecast) of power consumption 302 in kilowatts (kW) of the system of FIGS. 2 and 3 executing the sequence of jobs over time 204. The arrows 206, 208, 210, 212 from FIGS. 2 and 3 noting start and end times of jobs are given in FIG. 4. In the illustrated embodiment, the power curve 304 is affected by the use of local generation of energy, as indicated by region 404. While the actual power consumed by the facility or HPC system may rise from 6,080 KW to 7,310 KW, the amount of actual demand of power consumed from the utility provider remains at 6,080 KW due to use of local generation of energy. Thus, an allocated demand 406 could be 6,080 KW without incurring a demand charge. Plus, the meter charge will be less. The subsequent demands 408 and 410 (2,560 KW and 4,940 KW) match the power curve 304.

Some embodiments may employ an estimator module to estimate power and time-to-completion of distributed computing job. Such an estimator tool that estimates power of job may be employed in order to develop a power forecast for the datacenter. The estimator may utilize data provided by a calibrator, for example, that calibrates nodes of the datacenter. The estimator may rely, in part, on such a calibrator to develop a power estimate for both maximum power and average power needed for a job. As for output, the estimator may also provide an estimate for how long (time) the job may take to complete.

Embodiments herein may also rely on or accommodate estimating sequence of job execution. In particular, a software utility or job forecaster may help a system resource manager to develop a sequence, for example. Conventionally, a resource manager may schedule and launch jobs based upon a number of factors, such as priority of jobs, available nodes, required nodes, etc. However, a job forecaster may in addition, model these actions and actors to develop a sequence. The FIG. 3 discussed above may be an example output from a job forecaster.

In some embodiments, a new power forecast (energy forecast) may be developed every time (or nearly every time) there is an occurrence of either a job-related event, i.e., job event, or an energy event. Examples of job-related events include a user submitting a job, reshuffling in priority of jobs, or start of a job, when a running job completes, crashes or is suspended. Examples of energy events include change in status or capacity of local generation of energy, change in capacity of local storage of energy, or change in pricing of energy beyond predefined thresholds.

In sum, a job event, an energy event, or other event, may trigger generation and reevaluation of the energy forecast for the facility. In implementation, upon the occurrence of a job event or an energy event, stored executable code (e.g., a facility power manager) may initiate and update a facility energy forecast. As a part of generation of such a forecast, the facility power manager may ask for an up-to-date energy forecast from each system located in the facility. In some examples, the update of the energy forecast is initiated in response to job event or energy event, plus an additional factor or criterion.

In general, embodiments are directed to forecasting power demand for a datacenter. An estimator determining power estimates of jobs, and a job forecaster further considering job sequencing and other factors, may provide for input to develop a forecast for demand for the datacenter. This forecast may also generally comprehend other energy consumers at the datacenter, such with respect to power conversion efficiency, cooling systems, building lighting, etc. The forecast developed may be a baseline forecast which can be modified to comprehend the following to reduce cost of energy: (1) consideration of utility incentive programs such with respect to time of the day, (2) use of renewable energy, (3) use of local energy storage and generation, (4) spot pricing of the energy, and so forth.

Datacenters that host HPC systems will continue to increase in energy consumption. The specified allocated power demand with the utility provider may reach as much as 40-45 MW and greater. However, at times during such high allocation, the actual demand or consumption of energy at the datacenter may commonly be lower that the specified demand allocation. Thus, as discussed, techniques for developing power forecasts and automated adjustment of specified demand may be beneficial.

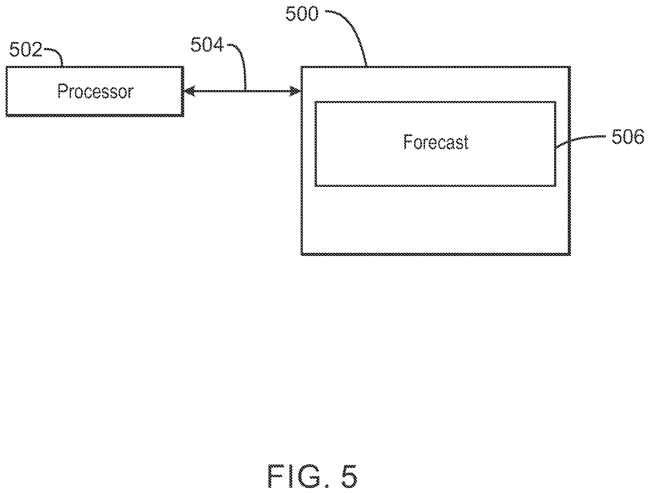

FIG. 5 is a block diagram depicting an example of a tangible non-transitory, computer-readable medium that can facilitate power forecasting and management with respect to a distributed computing system and facility in accordance with embodiments of the present techniques. The computer-readable medium 500 may be accessed by a processor 502 over a computer interconnect 504. The processor 502 may be one or more compute node processors (e.g., 103), a server processor (e.g., 116), or another processor. The tangible, non-transitory, computer-readable medium 500 may include executable instructions or code to direct the processor 502 to perform the operations of the techniques described herein.

The various software components discussed herein may be stored on the tangible, non-transitory, computer-readable medium 500, as indicated in FIG. 5. For example, a power forecast module 506 (executable code/instructions) may direct the processor 502 to determine power consumption and demand for a distributed computing system and at a distributed computing facility. The code or module 506 may be similar or the same as the aforementioned executable code 107, 120 in FIG. 1. It should be understood that any number of additional software components not shown in FIG. 5 may be included within the tangible, non-transitory, computer-readable medium 500, depending on the application.

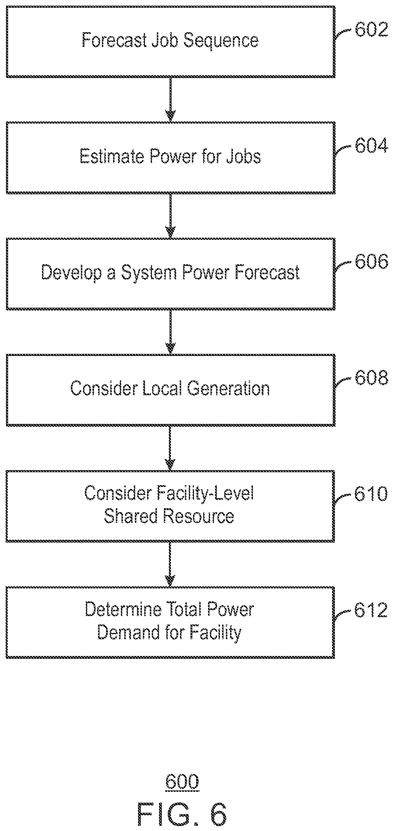

FIG. 6 is a method 600 of forecasting power consumption a distributed computing facility. The distributed computing facility may have nodes for executing jobs of distributed computing. The method 600 may be performed by a computer, a processor, a node, and so on.

To forecast power consumption at the facility, the sequence of job execution on a system of nodes may be estimated (block 602). Further, the power of the jobs on the system may be estimated (block 604). To estimate the power of the jobs to run on the system of nodes, the following may be employed or considered: (1) use of historical data scaled based upon nodes; (2) node power including average and maximum power; (3) shared power such as that associated with networking, file systems, and so on; (4) losses in power and energy efficiency. Of course, other factors may be considered for job and system-level power.

The method 600 includes developing (block 606) a power profile or power forecast of the system of nodes. The power profile(s) or power forecast may be a maximum power profile, an average power profile, and so forth. As discussed above, the power profile or power forecast at the system level may be based on or correlative with the forecasted sequence of job execution and the estimated power for the jobs. Further, for facility-level power estimating, the method 600 may further consider (block 608) local generation and/or local storage of energy, as well as facility-level energy consumers (e.g., shared resources such as lighting and cooling), in addition to the systems-level power estimate or forecast. It should be noted, that the consideration (block 608) may involve actively adjusting operation of the local generation or storage.

Lastly, the method includes determining (block 610) total actual power demand by the distributed computing facility. The total actual power demand to the utility provider(s) may be the forecasted power consumption of the facility minus any local generation of power, for example. The total actual demand may be based, in part, on the sum of the power consumption of one or more systems of nodes at the distributed computing facility. Moreover, the determining (block 610) of the total actual power demand may involve active adjustments of actual power demand such as via implementation of local energy generation or storage.

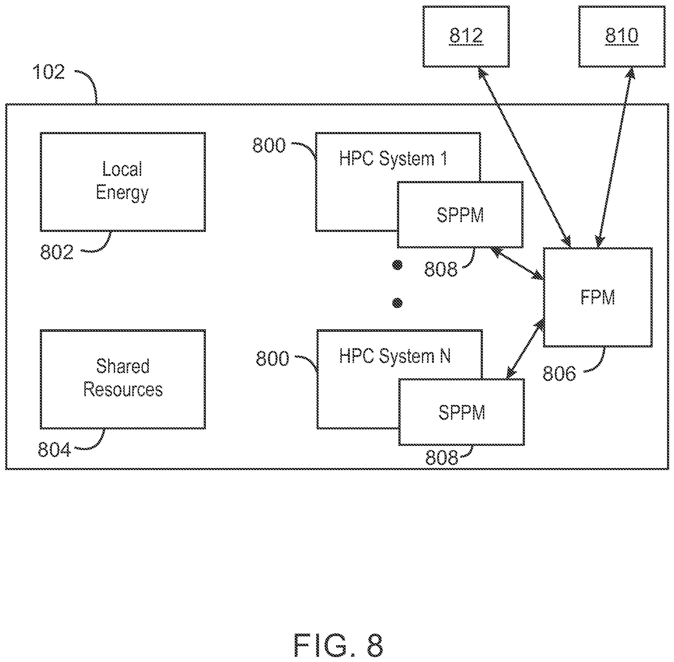

With respect to system level for the power or energy forecast, the estimator in developing (block 606) a system power forecast may estimate power needs for a job. A system power performance manager (SPPM) (see, e.g., FIG. 8), for example, may generate an estimate forecast for power needs for a system of nodes or compute units, executing multiple jobs. To develop such a system-level forecast, the SPPM in addition to the system computing power demands, may comprehend system-level overhead such as losses in the shared power and cooling infrastructure, and power needs for system level shared resources such as storage systems, networking infrastructure, and so on.

As for the facility level, a facility power manager (FPM), for example, may generate an energy or power forecast using power forecasts for all the systems in the facility or datacenter. The FPM may need to account for systems that do not have capability to develop a system forecast. For such systems, the FPM may use historical information of usage of power or use traditional approach of worst case power demand. The FPM will typically also comprehend losses in facility level power conversion and cooling, for instance. Further, the FPM will generally account for power usage by shared resources at facility level. Examples of such shared resources are office area and building management system lighting and cooling.

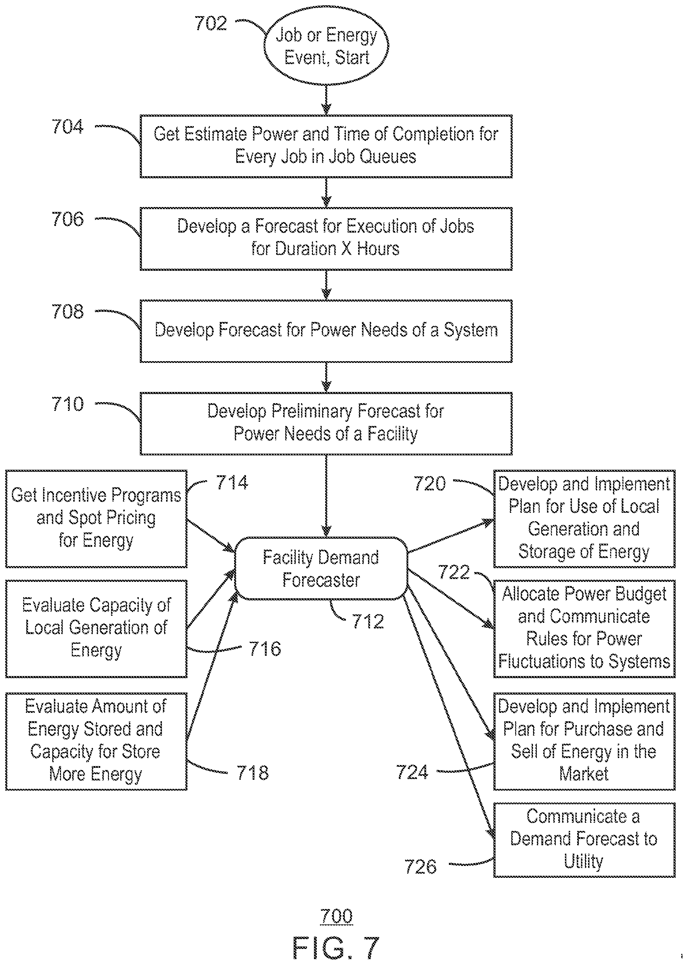

FIG. 7 is a method 700 of forecasting power consumption a facility, such as a distributed computing facility. The development, reevaluation, or update of a power forecast may be initiated (block 702) by a job event or energy event, for example. For an HPC system of nodes, for example, the power and time of completion for most or all jobs in the system job queues may be estimated (block 704). Thus, energy or power forecast for the execution of the jobs for duration of X hours may be developed (block 706). Then, a forecast for power needs of the system may be developed (block 708). Such may include energy consumption via shared resources at the system level.

At the facility level, a preliminary forecast for power needs of the facility may be determined (block 710). This demand may be based upon forecast of power for most or all systems in the facility. This preliminary forecast for the facility may be developed by or fed to a facility demand forecaster 712 (module or executable code). Then, the facility demand forecaster 712 may consider other factors. For example, the forecaster 712 may consider incentive programs and spot pricing for energy (block 714), capacity of local generation of energy (block 716), and the amount of energy stored and the capacity to store more energy (718). Of course, the facility demand forecaster 712 may consider additional information and other factors.

The output of the facility demand forecaster 712 may be to develop and implement a plan for use of local generation and storage of energy (block 720), a plan for purchase and sell of energy in the market (block 724), and other plans. Further, as noted by block 722, the forecaster 712 may allocate a power budget may communicate rules for power fluctuations to systems. Indeed, the forecaster 712 output may include various communications. For example, the output may be to communicate (block 426) a demand forecast for the facility to the utility, i.e., the utility company or provider. Lastly, it should be noted that the facility demand forecaster 712 may be directed by or part of a facility power manager (FPM).

FIG. 8 is an example facility 102 for distributed computing having multiple HPC systems 800 of nodes for computing. As can be appreciated, such computing consumes power. Other consumers of power at the facility 102 may be shared resources 804, such as cooling, lighting, and other shared resources and other consumers. Additional facility consumption in power may also include efficiency losses with respect to power conversion, for example, and by other users or consumers at the facility. As for receipt of energy, the power supplied to the facility 102 from a utility company or distributor may be supplemented by generation and/or the storage of local energy 802. The generation of local energy 802 can be performed for multiple reasons including power ramp and band control, reducing changes in demand for energy (demand communicated from facility to utility company), decrease cost of energy by generating locally when utility cost is high, develop revenue by selling locally generated energy when cost of energy is high by the utility company or on the market, and so forth. It should be noted with respect power ramp control, utility providers may dictate that fluctuations in power consumption are to be controlled and occur at slow rates. A power ramp control referring to techniques to dampen a sudden change in power consumption, for example to an acceptable level or more gradual change. With respect to power band control, utility providers may expect facilities to maintain power consumption within a range of allocation. That is if allocated power is 10 MW, the utility provider may expect power consumption by the facility be between 8 to 10 MW. These minimum and maximum levels of power may be referred to as power band.

A facility power manager (FPM) 806 may develop a power forecast for the facility. To develop, reevaluate, or update the facility power forecast, the FPM 806 may communicate with a system power-performance manager (SPPM) 808 at each system 800 of nodes to comprehend system-level computing power needs and system-level shared-resource power needs. The SPPM 808 will generally determine or update system-level power forecasts/profile for sequencing and power estimates of distributed computing jobs, as discussed above. Of course, the SPPM 808 may be involved with or direct a variety of power-performance issues and controls at the system level.

To develop or update the facility power forecast, the FPM 806 will also consider facility-level consumers including shared resources 804 (lighting, etc.) and local energy 802 generation/storage at the facility level, as discussed. The FPM 806 may develop or determine a value for total power demand for the facility 102. This value for power demand may be communicated from the FPM 806 to the utility company 810 (provider, distributer, supplier, etc.) supplying electricity (power) to the facility 102. Of course, the FPM 806 may be in communication with the utility company 810 regarding other issues. Moreover, in the illustrated embodiment, the FPM 806 may be in communication with a facility manager or administrator 812, for instance. This communication may involve, for example, facility rules and policies, including with respect to power.

In addition to forecasting power and developing or updating demand, the FPM 806 may be involved in a variety of other facility controls. The FPM 806 gives direction to the multiple system managers SPPM 808 for the systems 800 of nodes. Further, again, the FPM 806 may communicate with and have policies/rules set with a human administrator 812, utility company or provider 810, and so forth. In examples, the FPM 806 may be or use a demand/response interface to the utility provider 810. Moreover, the FPM 806 may perform accountings of power and cooling at the facility 102, and the like, including to communicate capacity and requirements. The FPM 806 may account for a cooling system (of 804), manage generation of local energy 802, allocate power budgets to the one or more SPPM 808, and so forth.

A FPM 806 may use various mechanisms to meet requirements by the datacenter operator with respect to power consumption variation, such as for delta Watts per minute (ΔW/min) and ΔW/hour. A datacenter operator may also have the FPM 806 maintain facility-level power consumption at, or slightly below, power allocation by the utility provider 302. With targets to keep energy efficiency high, the FPM 806 may attempt to employ green mechanisms before resorting to non-green mechanisms.

For a facility 102 with generators of local energy 802, the FPM 808 may use local energy 802. Depending on the particular facility 102, there may be various types of local generators of energy. Examples of local generators are diesel engines, solar power, and so forth. In a particular example, if facility 102 demand for power as negotiated with the utility provider 810 is set at say 12 MW, and the facility 102 has local power 802 generation of 2 MW, for instance, then the facility 102 may instead renegotiate demand for 10 MW from the utility provider 810. If so, the utility provider 810 may require the facility 102 draw from the utility provider 810 between 8.5 MW to 10 MW (e.g., allowed variation of 15%), for example. In this numerical example, the 2 MW local energy 802 generation may facilitate datacenter facility 102 level fluctuation between 8.5 to 12MW (∼30% variation). Local power generation may therefore increase flexibility or level of power, as well as help meet goal(s) for limited variation (e.g., ΔW/hour) over the long term.

For a facility 102 with local power 802 storage, the FPM 808 may use the power 802 storage (e.g., battery, local refrigeration, etc.). When facility 102 level actual power consumption may fall below minimum demand (say 8.5 MW in the above numerical example), the FPM 808 may channel energy to charge batteries 140 part of the local energy 802. The resulting battery charge may later then be used when facility 102 actual demand for power grows. Another approach for energy 802 storage is to use excess energy (e.g., when actual power consumption of the facility drops below negotiated demand) to cool liquid or to generate ice. Ice or cool liquid can be stored and used later for savings in energy in the cooling system (e.g., of 804) when actual power consumption exceeds demand. Other examples of mechanisms the FPM 808 may employ is for the FPM 808 to designate settings on the cooling systems (e.g., a shared resource 804), such as adjusting the temperature or temperature set point of coolant, air, or water in the cooling system. Such control may affect power consumed by both the cooling system and the computing architecture of the systems 800.

Some embodiments may be implemented in one or a combination of hardware, firmware, and software. Some embodiments may also be implemented as instructions stored on a machine-readable medium, which may be read and executed by a computing platform to perform the operations described herein. A machine-readable medium may include any mechanism for storing or transmitting information in a form readable by a machine, e.g., a computer. For example, a machine-readable medium may include read only memory (ROM); random access memory (RAM); magnetic disk storage media; optical storage media; flash memory devices; or electrical, optical, acoustical or other form of propagated signals, e.g., carrier waves, infrared signals, digital signals, or the interfaces that transmit and/or receive signals, among others.

The present techniques are not restricted to the particular details listed herein. Indeed, those skilled in the art having the benefit of this disclosure will appreciate that many other variations from the foregoing description and drawings may be made within the present techniques. Accordingly, it is the following claims including any amendments thereto that define the scope of the present invention.

## Claims

1. A distributed computing facility (100) comprising:
nodes (102) configured to execute jobs of distributed computing; and
memory (107) storing code executable by the nodes (102) or a processor to forecast power consumption by the distributed computing facility (100), comprising to:
forecast sequence of jobs execution on a system of the nodes (102) over time;
estimate power for the jobs of the system; and
develop a system-level power forecast (304) of the system (100), wherein the system-level power forecast is correlative with the sequence of job execution and the power for the jobs; and **characterized in that**:
the code is executable to activate or increase local energy generation in response to the forecast (304) of power consumption exceeding a specified demand (406), and wherein the system-level power forecast comprises a predicted power profile of the system.

2. The facility (100) of claim 1, wherein to forecast power consumption comprises to develop a forecast (304) of total actual demand for the distributed computing facility (100).

3. The facility (100) of claims 1 and 2, wherein to develop the forecast (304) of total actual demand comprises considering local power generation at the distributed computing facility, and wherein the total actual demand (406) comprises the power consumption minus an amount (404) of local power generated at the distributed computing facility (100).

4. The facility (100) of claims 1 and 2, wherein to forecast (304) power consumption comprises to forecast power consumption in response to a job event or an energy event, or a combination thereof.

5. The facility (100) of claims 1 and 2, wherein the code is executable to adjust use of local energy generation (802) or energy storage, or both, at the distributed computing facility (100) in response to changing demand of power or changing pricing of energy, or both.

6. The facility (100) of claims 1 and 2, wherein the code is executable to adjust total actual demand (406) of power by the distributed computing facility in response to an incentive program by a utility provider or in response to spot pricing of energy, or a combination thereof.

7. The facility (100) of claims 1 and 2, wherein the distributed computing facility comprises a high performance computing, HPC, facility or a Big Data analytics facility, or a combination thereof.

8. A method (600) of operating a distributed computing facility (100), comprising:
executing jobs of distributed computing on systems of nodes (102) of the distributed computing facility (104);
forecasting, via a processor, power consumption of the distributed computing facility, wherein forecasting the power consumption comprises:
forecasting (602), via the processor, a sequence of jobs execution on a system of the nodes (102) over time;
estimating (604), via the processor, power for the jobs of the system; and
developing (606), via the processor, a system-level power forecast (406) of the system, wherein the system-level power forecast is correlative with the sequence of job execution and the power for the jobs; and **characterized by**:
activating (608) or increasing local energy generation at the distributed computing facility in response to a forecast of the power consumption exceeding a specified demand (406), and wherein the system-level power forecast comprises a predicted power profile of the system.

9. The method (600) of claim 8, wherein forecasting power consumption comprises forecasting total actual demand to a utility provider for the distributed computing facility.

10. The method (600) of claim 8, wherein forecasting power consumption comprises forecasting power consumption in response to a job event or an energy event, or both.

11. The method (100) of claim 8, comprising adjusting, via the processor, total actual demand of power in response to an incentive program or spot pricing of energy, or a combination thereof.

12. A computer program product comprising computer program code that, when executed, implements the method of any of claims 8 to 11.

## Patentansprüche

1. Verteilte Recheneinrichtung (100), die Folgendes umfasst:
Knoten (102), die dazu konfiguriert sind, Aufgaben einer verteilten Berechnung auszuführen; und
einen Speicher (107), der einen durch die Knoten (102) oder einen Prozessor ausführbaren Code speichert, um einen Leistungsverbrauch durch die verteilte Recheneinrichtung (100) vorherzusagen, das Folgendes umfasst:
Vorhersagen einer zeitlichen Sequenz der Aufgabeausführung in einem System der Knoten (102);
Abschätzen der Leistung für die Aufgaben des Systems; und
Entwickeln einer Systemebenenleistungsvorhersage (304) des Systems (100), wobei die Systemebenenleistungsvorhersage mit der Sequenz der Aufgabenausführung und der Leistung für die Aufgaben korreliert; und **dadurch gekennzeichnet, dass**:
der Code ausführbar ist, um die lokale Energieerzeugung in Reaktion auf die Vorhersage (304), dass der Leistungsverbrauch einen festgelegten Bedarf (406) überschreitet, zu aktivieren oder zu erhöhen, wobei die Systemebenenleistungsvorhersage ein prognostiziertes Leistungsprofil des Systems umfasst.

2. Einrichtung (100) nach Anspruch 1, wobei das Vorhersagen des Leistungsverbrauchs die Entwicklung einer Vorhersage (304) des gesamten aktuellen Bedarfs für die verteilte Recheneinrichtung (100) umfasst.

3. Einrichtung (100) nach den Ansprüchen 1 und 2, wobei die Entwicklung der Vorhersage (304) des gesamten aktuellen Bedarfs das Betrachten der lokalen Leistungserzeugung an der verteilten Recheneinrichtung umfasst und wobei der gesamte aktuelle Bedarf (406) den Leistungsverbrauch abzüglich einer Menge (404) der lokalen Leistung, die an der verteilten Recheneinrichtung (100) erzeugt wird, umfasst.

4. Einrichtung (100) nach den Ansprüchen 1 und 2, wobei die Vorhersage (304) des Leistungsverbrauchs die Vorhersage des Leistungsverbrauchs in Reaktion auf ein Aufgabenereignis oder ein Energieereignis oder eine Kombination davon umfasst.

5. Einrichtung (100) nach den Ansprüchen 1 und 2, wobei der Code ausführbar ist, um die Verwendung der lokalen Energieerzeugung (802) oder Energiespeicherung oder beider an der verteilten Recheneinrichtung (100) in Reaktion auf einen sich ändernden Bedarf an Leistung oder einen sich ändernden Preis von Energie oder beide einzustellen.

6. Einrichtung (100) nach den Ansprüchen 1 und 2, wobei der Code ausführbar ist, um den gesamten aktuellen Bedarf (406) an Leistung durch die verteilte Recheneinrichtung in Reaktion auf ein Anreizprogramm durch einen Versorgungsanbieter oder in Reaktion auf einen Ortspreis von Energie oder eine Kombination davon einzustellen.

7. Einrichtung (100) nach den Ansprüchen 1 und 2, wobei die verteilte Recheneinrichtung eine Hochleistungsrecheneinrichtung, HPC-Einrichtung, oder eine Analyseeinrichtung für große Datenmengen oder eine Kombination davon umfasst.

8. Verfahren (600) zum Betreiben einer verteilten Recheneinrichtung (100), das Folgendes umfasst:
Ausführen von Aufgaben einer verteilten Berechnung an Systemen von Knoten (102) der verteilten Recheneinrichtung (104);
Vorhersagen des Leistungsverbrauchs der verteilten Recheneinrichtung durch einen Prozessor, wobei die Vorhersage des Leistungsverbrauchs Folgendes umfasst:
Vorhersagen (602) einer zeitlichen Sequenz einer Aufgabenausführung in einem System der Knoten (102) durch den Prozessor;
Abschätzen (604) der Leistung für die Aufgaben des Systems durch den Prozessor; und
Entwickeln (606) einer Systemebenenleistungsvorhersage (406) des Systems durch den Prozessor, wobei die Systemebenenleistungsvorhersage mit der Sequenz der Aufgabenausführung und der Leistung für die Aufgaben korreliert; und **gekennzeichnet durch**:
Aktivieren (608) oder Erhöhen der lokalen Energieerzeugung an der verteilten Recheneinrichtung in Reaktion auf eine Vorhersage, dass der Leistungsverbrauch einen festgelegten Bedarf (406) überschreitet, wobei die Systemebenenleistungsvorhersage ein prognostiziertes Leistungsprofil des Systems umfasst.

9. Verfahren (600) nach Anspruch 8, wobei das Vorhersagen des Leistungsverbrauchs das Vorhersagen des gesamten aktuellen Bedarfs für einen Versorgungsanbieter für die verteilte Recheneinrichtung umfasst.

10. Verfahren (600) nach Anspruch 8, wobei das Vorhersagen des Leistungsverbrauchs das Vorhersagen des Leistungsverbrauchs in Reaktion auf ein Aufgabenereignis oder ein Energieereignis oder beide umfasst.

11. Verfahren (100) nach Anspruch 8, das das Einstellen des gesamten aktuellen Bedarfs an Leistung in Reaktion auf ein Anreizprogramm oder einen Ortspreis von Energie oder eine Kombination davon über den Prozessor umfasst.

12. Computerprogrammprodukt mit einem Computerprogrammcode, der, wenn er ausgeführt wird, das Verfahren nach einem der Ansprüche 8 bis 11 implementiert.

## Revendications

1. Installation informatique distribuée (100) comprenant :
des nœuds (102) configurés pour exécuter des tâches d'informatique distribuée ; et
une mémoire (107) mémorisant un code exécutable par les nœuds (102) ou un processeur pour prévoir une puissance consommée par l'installation informatique distribuée (100), comprenant :
la prévision de l'exécution d'une séquence de tâches sur un système des nœuds (102) dans le temps ;
l'estimation d'une puissance pour les tâches du système ; et
le développement d'une prévision de puissance au niveau système (304) du système (100), la prévision de puissance au niveau système étant en corrélation avec l'exécution de la séquence de tâches et la puissance pour les tâches ; et **caractérisée en ce que** :
le code est exécutable pour activer ou augmenter la génération d'énergie locale quand la prévision (304) de la puissance consommée dépasse une demande spécifiée (406), et dans laquelle la prévision de puissance au niveau système comprend un profil de puissance prédit du système.

2. Installation (100) selon la revendication 1, dans laquelle la prévision de la puissance consommée comprend le développement d'une prévision (304) d'une demande réelle totale pour l'installation informatique distribuée (100).

3. Installation (100) selon les revendications 1 et 2, dans laquelle le développement de la prévision (304) de la demande réelle totale comprend la considération d'une génération de puissance locale au niveau de l'installation informatique distribuée, et dans laquelle la demande réelle totale (406) comprend la puissance consommée moins une quantité (404) de puissance locale générée au niveau de l'installation informatique distribuée (100).

4. Installation (100) selon les revendications 1 et 2, dans laquelle la prévision (304) de la puissance consommée comprend la prévision de la puissance consommée en réponse à un événement de tâche ou à un événement d'énergie, ou à une combinaison des deux.

5. Installation (100) selon les revendications 1 et 2, dans laquelle le code est exécutable pour ajuster l'utilisation de la génération d'énergie locale (802) ou le stockage d'énergie, ou les deux, au niveau de l'installation informatique distribuée (100) en réponse à un changement de la demande de puissance ou un changement du tarif d'énergie, ou les deux.

6. Installation (100) selon les revendications 1 et 2, dans laquelle le code est exécutable pour ajuster la demande réelle totale (406) de puissance par l'installation informatique distribuée en réponse à un programme d'incitation par un fournisseur électrique ou en réponse à un tarif d'énergie au comptant, ou à une combinaison des deux.

7. Installation (100) selon les revendications 1 et 2, l'installation informatique distribuée comprenant une installation informatique de haute performance, HPC, ou une installation analytique Big Data, ou une combinaison des deux.

8. Procédé (600) d'exploitation d'une installation informatique distribuée (100) comprenant :
l'exécution de tâches d'informatique distribuée sur des systèmes de nœuds (102) de l'installation informatique distribuée (104) ;
la prévision, par le biais d'un processeur, d'une puissance consommée de l'installation informatique distribuée, la prévision de puissance consommée comprenant :
la prévision (602), par le biais du processeur, de l'exécution d'une séquence de tâches sur un système des nœuds (102) dans le temps ;
l'estimation (604), par le biais du processeur, d'une puissance pour les tâches du système ; et
le développement (606), par le biais du processeur, d'une prévision de puissance au niveau système (406) du système, la prévision de puissance au niveau système étant en corrélation avec l'exécution de la séquence de tâches et la puissance pour les tâches ; et **caractérisé par** :
l'activation (608) ou l'augmentation de la génération d'énergie locale au niveau de l'installation informatique distribuée quand une prévision de la puissance consommée dépasse une demande spécifiée (406), et dans lequel la prévision de puissance au niveau système comprend un profil de puissance prédit du système.

9. Procédé (600) selon la revendication 8, dans lequel la prévision de la puissance consommée comprend la prévision d'une demande réelle totale adressée à un fournisseur électrique pour l'installation informatique distribuée.

10. Procédé (600) selon la revendication 8, dans lequel la prévision de la puissance consommée comprend la prévision de la puissance consommée en réponse à un événement de tâche ou à un événement d'énergie, ou à une combinaison des deux.

11. Procédé (600)) selon la revendication 8, comprenant l'ajustement, par l'intermédiaire du processeur, de la demande réelle totale de puissance en réponse à un programme d'incitation ou un tarif d'énergie au comptant, ou à une combinaison des deux.

12. Produit-programme informatique comprenant un code de programme informatique qui, à son exécution, met en œuvre le procédé selon l'une quelconque des revendications 8 à 11.
